## Europäisches Patentamt
## European Patent Office
## Office européen des brevets

(11) Veröffentlichungsnummer: **0 180 856**
**B1**

(12) **EUROPÄISCHE PATENTSCHRIFT**

(45) Veröffentlichungstag der Patentschrift: **16.01.91**

(21) Anmeldenummer: **85113481.7**

(22) Anmeldetag: **23.10.85**

(51) Int. Cl.⁵: **H 05 K 7/14, H 05 K 5/00, H 05 K 5/02**

(54) **Elektrisches Gerät.**

(30) Priorität: **08.11.84 DE 8432684 u**

(43) Veröffentlichungstag der Anmeldung:
**14.05.86 Patentblatt 86/20**

(45) Bekanntmachung des Hinweises auf die
Patenterteilung:
**16.01.91 Patentblatt 91/03**

(84) Benannte Vertragsstaaten:
**AT BE CH DE FR GB IT LI LU NL SE**

(56) Entgegenhaltungen:
**EP-A-0 004 507
EP-A-0 040 753
DE-A-3 136 042
DE-U-7 138 612
DE-U-8 300 515
FR-A-2 532 811**

(73) Patentinhaber: **Stecker, Josef
Gustav-Cords-Strasse 7
D-5000 Köln 60 (DE)**

(72) Erfinder: **Stecker, Josef
Gustav-Cords-Strasse 7
D-5000 Köln 60 (DE)**

(74) Vertreter: **Selting, Günther, Dipl.-Ing. et al
Deichmannhaus am Hauptbahnhof
D-5000 Köln 1 (DE)**

Courier Press, Leamington Spa, England.

**Beschreibung**

Die Erfindung betrifft ein elektrisches Gerät mit einem blockförmigen Gerätegehäuse, das an mindestens einer Kante oder Seite eine Anschlußleiste mit mehreren Klemmteilen zum Anklemmen elektrischer Leitungen aufweist, und mit in dem Gerätegehäuse angeordneten elektrischen Bauteilen.

Es sind quaderförmige Gerätegehäuse bekannt, die zur Aufnahme elektrischer und/oder mechanischer Bauteile dienen und an ihrer Rückseite einen Stecker aufweisen, der an einem Steckersockel befestigt werden kann. Auf diese Weise können entsprechend bestückte Gerätegehäuse nach Art von Modulen benutzt werden. Normalerweise befinden sich die Bauteile im Innern des Gerätegehäuses in losem Zustand. Um sie an den Wänden des Gerätegehäuses befestigen zu können, sind Laschen, Verschraubungen u.dgl. vorzusehen. Dies erfordert eine individuelle Anpassung der Gerätegehäuse an die entsprechenden Bauteile. Die bekannten Gerätegehäuse weisen an mindestens einer Kante eine Anschlußleiste mit Klemmteilen auf. An jedem der Klemmteile kann eine elektrische Leitung kontaktgebend befestigt werden. Von der Klemmleiste stehen im Innern des Gerätegehäuses Anschlußstifte ab, die mit den entsprechenden Bauteilen verdrahtet sind.

Der Erfindung liegt die Aufgabe zugrunde, ein elektrisches Gerät der eingangs genannten Art zu schaffen, bei dem mindestens ein Bauteil in dem Gerätegehäuse festgelegt ist, ohne daß es individueller Befestigungsmittel an den glatten Wänden des Gerätegehäuses bedarf.

Die Lösung dieser Aufgabe besteht erfindungsgemäß darin, daß eines der Bauteile ein Block ist, der an seiner Außenwand Rippen aufweist, welche in Nuten der Anschlußleiste klemmend eingreifen.

Nach der Erfindung wird die Anschlußleiste, die das Gerätegehäuse an einer Kante oder Seite abschließt, zugleich als Halterung für ein Bauteil benutzt. Die Anschlußleiste weist einen aus Kunststoff bestehenden Isolierkörper auf, in den die Nuten ohne zusätzlichen Aufwand leicht eingeformt werden können. Diese Nuten werden als Klemmteile zur Befestigung des blockförmigen Bauteils benutzt. Das Bauteil besteht aus einem Vergußblock, der einen mit elektrischen Komponenten bestückten Schaltungsträger enthalten kann. Diesem Vergußblock sind die Rippen, die in die Nuten der Anschlußleiste eingedrückt oder eingeschoben werden, angeformt.

Ein wesentlicher Vorteil der Erfindung besteht darin, daß das Bauteil, das an der Anschlußleiste festgelegt wird, sich im Innern des Gerätegehäuses nicht bewegen kann und daß die Verbindungsleitungen, die die Anschlußstifte der Anschlußleiste mit entsprechenden Anschlußstiften des Bauteiles verbinden, sehr kurz sein können. Kurze Verbindungsleitungen sind wenig anfällig gegen das Induzieren von Störspannungen und sie vereinfachen die Leitungsführung innerhalb des Gerätes.

Gemäß einer bevorzugten Ausführungsform der Erfindung ist vorgesehen, daß die Anschlußleiste an ihrer Rückwand Anschlußstifte aufweist, daß die Nuten an der der Rückwand benachbarten Innenwand der Anschlußleiste angeordnet sind und daß die Anschlußstifte des Bauteils an der den Rippen abgewandten Seite dieses Bauteils angeordnet sind. Diese Ausgestaltung eignet sich insbesondere für solche Gerätegehäuse, bei denen das Anschlußstück eine Kante abschließt, so daß zwei Flächen des Anschlußstückes am Gerätegehäuse außen liegen, während an einer der inneren Flächen die Anschlußstifte und an der anderen inneren Fläche die Nuten zur Befestigung des Bauteils angeordnet sind.

Vorzugsweise sind an der Vorderseite des Gerätegehäuses zwei Anschlußleisten an parallelen Kanten angeordnet. Jede dieser Anschlußleisten kann ein anderes Bauteil tragen. Auf diese Weise können zwei gleiche oder unterschiedliche elektronische Bauteile in dem Gerätegehäuse untergebracht und fixiert werden, ohne daß es separater Verbindungsmittel oder Verschraubungen bedarf. Das Gerätegehäuse kann beispielsweise ein Netzteil enthalten, das beide Bauteile mit der geeigneten Versorgungsspannung versorgt. Der Anschluß der Signalleitungen an die Bauteile erfolgt dagegen über die Anschlußleiste. Auf diese Weise ist es möglich, in einem relativ kleinen Gerätegehäuse zwei oder mehr elektronische Bauteile bzw. Baugruppen platzsparend und in fester räumlicher Zuordnung anzubringen und mit einem einzigen Netzteil zu versorgen.

Das Bauteil kann einen — vorzugsweise bidirektionalen — Spannungs-Strom-Konverter enthalten. Derartige Spannungs-Strom-Konverter werden dazu benutzt, Computer untereinander oder mit Peripheriegeräten über längere Datenleitungen zu verbinden. Auf längeren Datenleitungen muß die Datenübertragung nicht mit Spannungsimpulsen, sondern mit Stromimpulsen erfolgen, um die Leitungsverluste auszugleichen. Aus diesem Grund ist es üblich, an jedem Leitungsende einen bidirektionalen Spannungs-Strom-Konverter vorzusehen. Der sendeseitige Konverter wandelt die Spannungsimpulse am Ausgang des sendenden Geräts in Stromimpulse um, die über die Datenleitung übertragen werden, und der empfangsseitige Konverter wandelt die Stromimpulse wieder in Spannungsimpulse um, die dem empfangenden Datengerät zugeführt werden. Das erfindungsgemäße elektrische Gerät wird in der Nähe eines Datengerätes am Ende der Datenleitung installaliert. Da ein Datengerät an zahlreiche Datenleitungen angeschlossen sein kann, ist es wichtig, eine Vielzahl von Konvertern in die Nähe des Datengerätes auf kleinem Raum unterbringen zu können.

Bei dem erfindungsgemäßen elektrischen Gerät kann das Gerätegehäuse an seiner Rückseite einen Stecker zur Befestigung an einem Stecksockel aufweisen. Der Stecksockel kann an einer Wand oder beispielsweise auch an der Rückwand eines Hauptgehäuses, z.B. eines Schaltschranks, angebracht sein. Auf diese Weise ist es möglich, zahlreiche Gerätegehäuse auf engem Raum steckbar anzubringen, wobei jedes Gerätegehäuse eines oder mehrere elektronische Bauteile enthält, die vorzugsweise aus einem Spannungs-Strom-Konverter bestehen. Der Stecksockel kann an einer Schiene befestigt sein, die in einem mehrere Gerätegehäuse enthaltenden Hauptgehäuse angebracht ist.

In vorteilhafter Weiterbildung der Erfindung weist das Hauptgehäuse an seiner Vorderseite ein Fenster auf, durch das die Frontseiten der Gerätegehäuse sichtbar sind und an den Frontseiten sind Leuchtelemente angeordnet. Die Frontseite eines jeden Gerätegehäuses ist vorzugsweise eine Platte, die zwischen zwei die vorderen Gehäusekanten bildenden Anschlußleisten befestigt ist. Die Leuchtelemente zeigen den Datenfluß an und ermöglichen eine einfache optische Kontrolle des Funktionierens des Bauteils und der Überwachung auf richtige Leitungsführung, ohne das Hauptgehäuse oder das Gerätegehäuse öffnen zu müssen.

Im folgenden wird unter Bezugnahme auf die Zeichnungen ein bevorzugtes Ausführungsbeispiel der Erfindung näher erläutert.

Es zeigen.

Fig. 1 eine perspektivische Darstellung des Gerätegehäuses,

Fig. 2 einen Längsschnitt durch das Gerätegehäuse als Explosionsbild,

Fig. 3 eine Anschlußleiste mit zugehörigem elektrischem Bauteil, und

Fig. 4 eine perspektische Ansicht eines Hauptgehäuses, das mehrere Gerätegehäuse enthält.

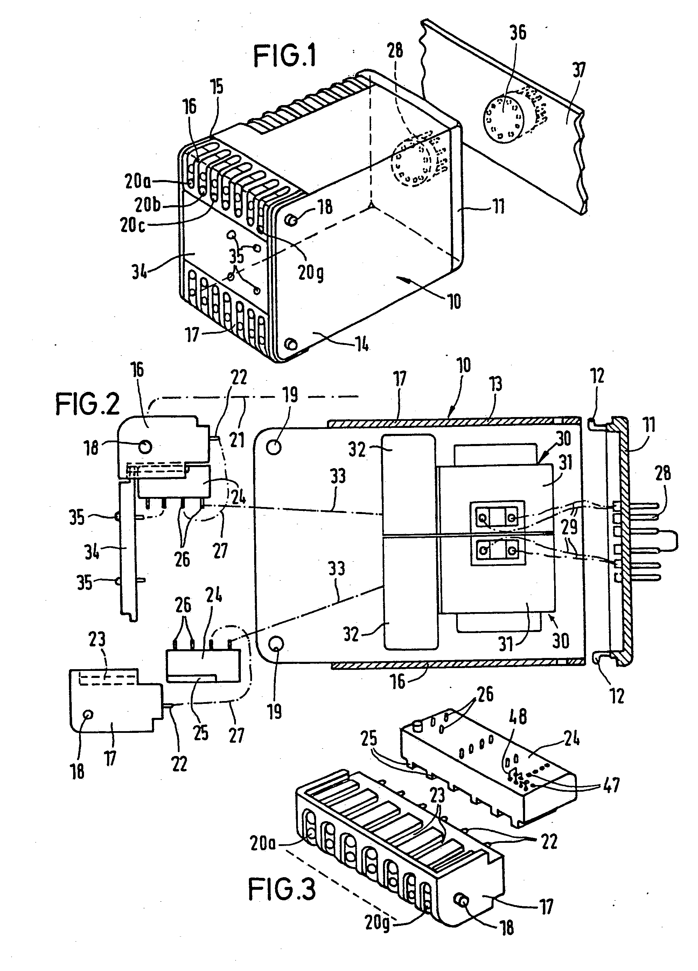

Das in den Fign. 1 und 2 dargestellte Gerätegehäuse 10 ist ein rohrförmiger rechteckiger Hohlkörper, bei dem die Rückwand 11 mit Klemmteilen 12 an dem rohrförmigen Gehäusekörper 13 befestigt ist. Die beiden einander gegenüberliegenden parallelen Seitenwände 14 und 15 überragen die hierzu rechtwinkligen, untereinander parallelen Seitenwände 16 und 17 nach vorne hin. Zwischen den Seitenwänden 14 und 15 sind zwei Anschlußleisten 16, 17 befestigt, von denen jede eine vordere Kante des Gerätegehäuses 10 bildet. An den Enden der Anschlußleisten 16 und 17 befinden sich Zapfen 18, die in entsprechende Löcher 19 der überstehenden Teile der Seitenwände 14 und 15 hineinragen, um die Anschlußleisten 16 und 17 an dem Gerätegehäuse 10 zu fixieren. Jede der Anschlußleisten 16 und 17 weist sieben Klemmteile 20a bis 20g auf. Diese Klemmteile 20a bis 20g sind metallische Klemmen, die gegeneinander isoliert und an die eine Datenleitung 21 angeschlossen werden kann. Die Klemmteile können beispielsweise als Schraubklemmen ausgebildet sein. Jede dieser Klemmen ist mit einem Anschlußstift 22 verbunden, der von der rückwärtigen Innenseite der Anschlußleiste 16 bzw. 17 absteht.

Die Anschlußleisten 16 und 17 weisen an ihren einander zugewandten Innenseiten Nuten 23 auf, die quer zur Längsrichtung zu der betreffenden Anschlußleiste verlaufen. Diese Nuten 23 dienen als Klemmteile zur Befestigung des Bauteils 24.

Dieses Bauteil besteht aus einem im wesentlichen rechteckigen Block, der etwas kürzer ist als die zugehörige Anschlußleiste und der an seiner Unterseite Stege 25 aufweist, welche klemmend in die Nuten 23 der Anschlußleiste eingeschoben werden können. Das Bauteil 24 enthält einen (nicht sichtbaren) mit elektronischen Bauteilen bestückten Schaltungsträger, der von einer Vergußmasse, die den Block bildet, umschlossen ist. Aus der Vergußmasse ragen auf der den Rippen 25 abgewandten Seite Anschlußstifte 26 heraus. Außerdem sind an der Oberseite des Blocks Kontaktbuchsen 47, vorgesehen, die wahlweise durch Kontaktbrücken 48 untereinander verbunden werden können, so daß die unterschiedlichen Betriebsarten "aktiv" oder "passiv" in den beiden Stromschleifen eingestellt werden können.

An der Rückwand 11 des Gerätegehäuses 10 ist ein Vielfachstecker 28 für die Stromversorgung angebracht. Von dem Vielfachstecker 28 führen Leitungen 29 zu zwei im Innern des Gerätegehäuses 10 untergebrachten Netzteilen 30, von denen jedes einen Transformator 31 und Kondensatoren 32 sowie eine Gleichrichterbrücke aufweist. Jedes Netzteil 30 hat solche Abmessungen, daß seine Komponenten sich an den Wänden des Gerätegehäuses 10 abstützen und dadurch festgelegt sind. Von jedem Netzteil 30 führen Versorgungsleitungen 33 zu bestimmten Anschlußstiften 26 eines der Bauteile 24. Weitere Leitungen 27 verbinden die Anschlußstifte 22 der Anschlußleiste 16 bzw. 17 mit bestimmten Anschlußstiften 26 des zugehörigen Bauteils 24.

Jedes Bauteil 24 enthält die Schaltung eines bidirektionalen Spannungs-Strom-Konverters. Die Klemmteile 20a bis 20g sind an der jeweiligen Anschlußleiste wie folgt bezeichnet:

20a: T×D (Transmit Data)
20b: R×D (Receive Data)
20c: SGD (Signal Ground)
20d: T+ (Pluspol der Transmit-Leitung)
20e: T− (Minuspol der Transmit-Leitung)
20f: R+ (Pluspol der Receive-Leitung)
20g: R− (Minuspol der Receive-Leitung).

Die Klemmen 20a bis 20c dienen zum Senden bzw. Empfangen der Spannungsimpulse und die Leitungen 20c bis 20g dienen zum Senden bzw. Empfangen der Stromimpulse.

Spannungsimpulse die an den Klemmen 20a, 20c empfangen wurden, werden als Stromimpulse an den Klemmen 20d, 20e ausgesandt. Stromimpulse die an den Klemmen 20f, 20g empfangen wurden, werden als Spannungsimpulse an den Klemmen 20b, 20c ausgesandt.

Die Vorderwand des Gerätegehäuses wird von einer platte 34 gebildet, die sich zwischen den Anschlußleisten 16, 17 und zwischen den Seitenwänden 14 und 15 erstreckt und an der Leuchtdioden 35 angebracht sind. Jeweils zwei verschiedenfarbige Leuchtdioden 35 sind mit einem der Bauteile 24 verbunden, um den Betrieb des Konverters in der einen oder der anderen Richtung anzuzeigen.

Wie Fig. 1 zeigt, wird der Stecker 28 in einen Stecksockel 36 eingesteckt, der an einer Schiene 37 befestigt ist.

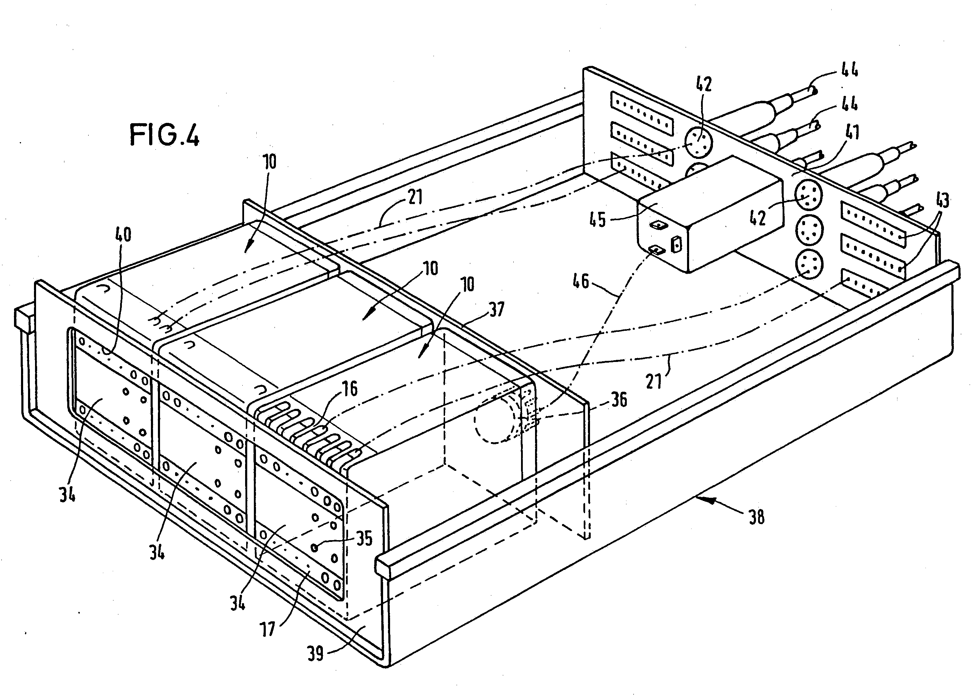

Fig. 4 zeigt die Unterbringung von drei Gerätegehäusen 10 in einem rechteckigen Hauptgehäuse 38, das in geöffnetem Zustand dargestellt ist. In der Frontseite 39 des Hauptgehäuses 38 befindet sich ein Fenster 40 mit einer durchsichtigen Scheibe. Hinter diesem Fenster 40 sind die Frontseiten 34 mit den Leuchtdioden 35 sichtbar. An der Rückwand 41 des Hauptgehäuses 38 sind mehrere Rundstecker angebracht, an die jeweils eine externe Datenleitung 44 angeschlossen werden kann. Jeder Rundstecker 42 ist beispielsweise über drei Leitungen 21 mit Spannungsklemmen 20a bis 20c einer Anschlußleiste 16 bzw. 17 verbunden und jeder Flachstecker 43 ist über vier Leitungen 21 mit den Stromklemmen 20d bis 20g einer Anschlußleiste verbunden. Die Leitungen 21 führen also von der Rückwand 43 aus, durch das Hauptgehäuse 38 hindurch, bis zu den in der Nähe der Vorderwand 39 angeordneten Anschlußleisten 16 bzw. 17. Die Stromversorgung der einzelnen Gerätegehäuse 10 erfolgt von einem gemeinsamen Verteiler 45 aus, der an der Rückwand 41 befestigt ist und von dem Versorgungsleitungen 46 zu den jeweiligen Stecksockeln 36 führen.

Fig. 4 zeigt eine Möglichkeit, wie mehrere Gerätegehäuse 10 in einem Hauptgehäuse 38 untergebracht sein können. Wenn eine größere Anzahl von Gerätegehäusen untergebracht werden muß, kann dies nach dem dargestellten Prinzip auch in einem größeren Schaltschrank erfolgen.

**Patentansprüche**

1. Elektrisches Gerät mit einem blockförmigen Gerätegehäuse (10), das an mindestens einer Kante oder Seite eine Anschlußleiste (16, 17) mit mehreren Klemmteilen (20a bis 20g) zum Anklemmen elektrischer Leitungen aufweist und mit in dem Gerätegehäuse (10) angeordneten elektrischen Bauteilen, dadurch gekennzeichnet, daß mindestens eines der Bauteile (24) ein Block ist, der an einer Außenwand Rippen (25) aufweist, welche in Nuten (23) der Anschlußleiste (16, 17) klemmend eingreifen.

2. Elektrisches Gerät nach Anspruch 1, dadurch gekennzeichnet, daß die Anschlußleiste (16, 17) an ihrer Rückwand Anschlußstifte (22) aufweist, daß die Nuten (23) an der der Rückwand benachbarten Innenwand der Anschlußleiste (16, 17) angeordnet sind und daß die Anschlußstifte (26) des Bauteils (24) an der den Rippen (25) abgewandten Seite dieses Bauteils angeordnet sind.

3. Elektrisches Gerät nach Anspruch 1 oder 2, dadurch gekennzeichnet, daß das Bauteil (24) ein im wesentlichen rechteckiger Block ist.

4. Elektrisches Gerät nach einem der Ansprüche 1 bis 3, dadurch gekennzeichnet, daß an der Vorderseite des Gerätegehäuses (10) zwei Anschlußleisten (16, 17) an parallelen Kanten angeordnet sind.

5. Elektrisches Gerät nach einem der Ansprüche 1 bis 4, dadurch gekennzeichnet, daß das Bauteil (24) einen vorzugsweise bidirektionalen Spannungs-Strom-Konverter enthält.

6. Elektrisches Gerät nach einem der Ansprüche 1 bis 5, dadurch gekennzeichnet, daß das Gehäuse (10) an seiner Rückseite einen Stecker (28) zur Befestigung an einem Stecksockel (36) aufweist.

7. Elektrisches Gerät nach Anspruch 6, dadurch gekennzeichnet, daß der Stecksockel (36) an einer Schiene (37) befestigt ist, die in einem mehrere Gerätegehäuse (10) enthaltenden Hauptgehäuse (38) angebracht ist.

8. Elektrisches Gerät nach Anspruch 7, dadurch gekennzeichnet, daß das Hauptgehäuse (38) an seiner Vorderseite ein Fenster (40) aufweist, durch das die Frontseiten der Gerätegehäuse (10) sichtbar sind und daß an den Frontseiten Leuchtelemente (35) angeordnet sind.

9. Elektrisches Gerät nach einem der Ansprüche 1 bis 8, dadurch gekennzeichnet, daß zwei Netzteile (30), die gegeneinander abgestützt sind, zwischen den Seitenwänden des Gerätegehäuses klemmend gehalten sind.

10. Elektrisches Gerät nach einem der Ansprüche 1 bis 9, dadurch gekennzeichnet, daß das Bauteil (24) an der den Rippen (25) abgewandten Seite Kontaktbuchsen (47) aufweist, die durch Steckbrücken (48) verbindbar sind.

11. Elektrisches Gerät nach einem der Ansprüche 1 bis 10, dadurch gekennzeichnet, daß das Bauteil (24) an der den Rippen (25) abgewandten Seite Steckbuchsen für Signalisierungsdrähte von Leuchtdioden (35) aufweist.

**Revendications**

1. Appareil électrique à boîtier d'appareil (10) en forme de bloc présentant, sur au moins un bord ou côté, une barre de raccordement (16, 17) à plusieurs bornes (20a à 20g) pour la connexion de lignes électriques et à composants électriques disposés dans le boîtier d'appareil (10), caractérisé en ce qu'au moins l'un des composants (24) est un bloc présentant, sur une paroi extérieure, des nervures (25) venant en prise serrée dans des rainures (23) de la barre de raccordement (16, 17).

2. Appareil électrique suivant la revendication 1, caractérisé en ce que la barre de raccordement (16, 17) présente, sur sa paroi arrière, des broches de connexion (22), que les rainures (23) sont disposées sur la paroi intérieure de la barre de raccordement (16, 17) adjacente à la paroi arrière et que les broches de connexion (26) du composant (24) sont disposées du côté de ce composant opposé aux rainures (25).

3. Appareil électrique suivant la revendication 1 ou 2, caractérisé en ce que le composant (24) est un bloc sensiblement rectangulaire.

4. Appareil électrique suivant l'une des revendications 1 à 3, caractérisé en ce que, du côté avant du boîtier d'appareil (10), deux barres de raccordement (16, 17) sont disposées sur des bords parallèles.

5. Appareil électrique suivant l'une des revendications 1 à 4, caractérisé en ce que le composant (24) contient un convertisseur de tension-courant, de préférence bidirectionnel.

6. Appareil électrique suivant l'une des revendications 1 à 5, caractérisé en ce que le boîtier (10) présente, sur sa face arrière, une fiche (28) pour fixation à une douille de connexion (36).

7. Appareil électrique suivant la revendication 6, caractérisé en ce que la douille de connexion (36) est fixée sur un rail (37) placé dans un boîtier principal (38) contenant plusieurs boîtiers d'appareil (10).

8. Appareil électrique suivant la revendication 7, caractérisé en ce que le boîtier principal (38) présente, sur sa face avant, une fenêtre (40) à travers laquelle sont visibles les faces avant des boîtiers d'appareil (10) et en ce que des éléments lumineux (35) sont disposés sur les faces avant.

9. Appareil électrique suivant l'une des revendications 1 à 8, caractérisé en ce que deux adaptateurs de réseau (30), s'appuyant l'un contre l'autre, sont maintenus serrés entre les parois latérales du boîtier d'appareil.

10. Appareil électrique suivant l'une des revendications 1 à 9, caractérisé en ce que le composant (24) présente, du côté opposé aux nervures (25), des douilles de contact (47) pouvant être reliées par des ponts de connexion (48).

11. Appareil électrique suivant l'une des revendications 1 à 10, caractérisé en ce que le composant (24) présente, du côté opposé aux nervures (25), des douilles de contact pour fils de signalisation de diodes luminescentes (35).

## Claims

1. Electric apparatus having a parallelepipedical apparatus housing (10), at least one edge or side of said apparatus housing (10) being provided with a connector strip (16, 17) having a plurality of clamping members (20a-20g) for clamping attachment of electric conduits, and electric components arranged in said apparatus housing (10), characterized in that at least one of said components (24) is a block having one of its outer walls provided with ribs (25) for clamping engagement into grooves (23) of the connector strip (16, 17).

2. Electric apparatus according to claim 1, characterized in that the rear wall of the connector strip (16, 17) is provided with connector pins (22), that the grooves (23) are arranged on the inner wall of the connector strip (16, 17) adjacent to the rear wall and that the connector pins (26) of the component (24) are arranged at the side of this component averted from the ribs (25).

3. Electric apparatus according to claim 1 or 2, characterized in that the component (24) is a substantially rectangular block.

4. Electric apparatus according to any one of claims 1 to 3, characterized in that, at the front side of the apparatus housing (10), two connector strips (16, 17) are arranged at parallel edges.

5. Electric apparatus according to any one of claims 1 to 4, characterized in that the component (24) includes a, preferably bidirectional, voltage-to-current converter.

6. Electric apparatus according to any one of claims 1 to 5, characterized in that the housing (10) has its rear side provided with a plug (28) to be fastened to a socket (36).

7. Electric apparatus according to claim 6, characterized in that the socket (36) is fastened to a rail (37) being mounted in a main housing (38) accommodating a plurality of apparatus housings (10).

8. Electric apparatus according to claim 7, characterized in that the main housing (38) has its front side provided with a window (40) through which the front sides of the apparatus housings (10) are visible, and that luminous elements (35) are arranged at said front sides.

9. Electric apparatus according to any one of claims 1 to 8, characterized in that two power supply units (30), being supported against each other, are clampingly held between the side walls of the apparatus housing.

10. Electric apparatus according to any one of claims 1 to 9, characterized in that the component (24), at the side averted from the ribs (25), is provided with connector terminal sleeves (47) interconnectable by plug connector bridges (48).

11. Electric apparatus according to any one of claims 1 to 10, characterized in that the component (24), at the side averted from the ribs (25), is provided with connector terminal sleeves for signalling wires of light-emitting diodes (35).

FIG.1

FIG.2

FIG.3

FIG.4